# EUROPÄISCHE PATENTSCHRIFT

(11) **EP 3 959 739 B1**
(45) Veröffentlichungstag und Bekanntmachung des Hinweises auf die Patenterteilung: **28.05.2025**
(21) Anmeldenummer: 20728933.1
(22) Anmeldetag: 07.04.2020
(51) Int. Cl.: H01J 37/32, C23C 14/00, H01J 37/34, C23C 14/32

(54) **ANODE FÜR PVD-PROZESSE**
ANODE FOR PVD PROCESSES
ANODE POUR PROCESSUS PVD

(30) Priorität: 25.04.2019 DE 102019110642
(43) Veröffentlichungstag der Anmeldung: 02.03.2022
(73) Patentinhaber: VON ARDENNE GmbH, 01328 Dresden OT Weißig (DE)
(72) Erfinder: FUKAREK, Wolfgang, 01257 Dresden (DE); HOLZHERR, Martin, 01257 Dresden (DE)
(74) Vertreter: Novagraaf Group
(86) Internationale Anmeldenummer: PCT/DE2020/200024
(87) Internationale Veröffentlichungsnummer: WO 2020/216419

(56) Entgegenhaltungen:
- EP-A1- 0 904 426
- DE-A1- 102013 103 762
- US-A- 4 478 700
- US-A1- 2012 298 139

## Beschreibung

Die Erfindung betrifft eine Anode und eine Anodenanordnung in einer Vorrichtung zur Durchführung von Prozessen physikalischer Gasphasenabscheidung, ein Verfahren zur Herstellung einer solchen Anode sowie die Verwendung der Anode und der Vorrichtung, welche die Degradation der Anode aufgrund von Anlagerungen stark reduziert oder sogar verhindert.

Bei der Gasphasenabscheidung mittels PVD-Prozessen wird das zur Beschichtung verwendete Material zunächst durch Verdampfung, Sublimation oder Zerstäubung in seine Gasphase überführt und durch Entladungsvorgänge ganz oder teilweise ionisiert. Prozesse, die geeignet sind, Materie in den Plasmazustand versetzen, sind beispielsweise die Magnetronentladungen oder die Bogenentladungen.

Die Erzeugung der für den Lichtbogen notwendigen frei beweglichen elektrischen Ladungsträger kann in einem Vakuum durch Feldemission, Glühemission oder gezielte Ionisation des Kathodenmaterials erfolgen. Dabei wird häufig die gezielte Ionisation des Kathodenmaterials genutzt.

Vor der eigentlichen Beschichtung wird darauf geachtet, möglichst gute Haftungseigenschaften für das Beschichtungsmaterial auf dem Substrat herzustellen. Da sich Nitridschichten, Oberflächenoxide und Adsorbate wie Wasser und Kohlenwasserstoffe als in dieser Hinsicht besonders problematisch erwiesen haben, ist es gängige Praxis, diese vor dem eigentlichen Beschichtungsvorgang zu entfernen.

In WO 201 309 1802 A1 wird eine Methode zu Oberflächenbeschichtung mittels Bogenentladung beschrieben. Problematisch ist, dass sich während des Beschichtungsprozesses gelegentlich Kathodenmaterialcluster von der Kathode lösen. Dieses Problem wird hier durch die Verwendung von Magnetfeldern angegangen, welche den Wechselwirkungspunkt von Bogenentladung und Elektrodenoberfläche variieren. Die Verwendung von Magnetfeldern bewirkt, durch die Beeinflussung der geladenen Teilchen, jedoch nachteilig eine Verminderung der Beschichtungsraten.

In EP 3 196 331 A1 wird die Aufbringung von haftmindernden Schichten auf sich bewegende Substrate mittels PVD-Verfahren unter Verwendung einer Substratspannung beschrieben. Die Substrate werden dabei unter Spannung gesetzt, um Verluste des Beschichtungsmaterials an die Innenflächen der verwendeten PVD-Vorrichtung zu minimieren.

Bei den PVD-Prozessen wird Material einer Elektrode zerstäubt oder verdampft. Dabei wird die jeweilige Elektrode verbraucht und degeneriert somit durch den Prozess. Dies ist immer von einem Materialtransfer zur zugehörigen Gegenelektrode begleitet. Ist nun die degenerierende Elektrode die Kathode, so resultiert das Problem, dass es zu einer ungewollten Aufwachsung von Kathodenmaterial auf der Anode kommt. Diese Aufwachsungen verändern die geometrische Form der Anode und führen dazu, dass der Abstand zwischen den Oberflächen der Elektroden Änderungen unterliegt. Diese Änderung des Abstandes beeinflusst die Lichtbogenbedingungen negativ bis hin zum Erlöschen des Lichtbogens durch Kurzschluss der beiden Elektroden.

Für Magnetronentladungen sind verschiedene Lösungen zur Vermeidung der Anodenbeschichtung durch Anlagerungsprozesse bekannt. Hierzu gehören die versteckte Anode (hidden anode) und die bipolare Entladung.

Bei der versteckten Magnetronanode wird das Plasma durch ein Magnetfeld hinter den Sichtbereich der Kathode gelenkt, wodurch nur geladene Partikel die Anode erreichen können. Auf Bogenentladungen ist dies nicht anwendbar, da das verdampfte Material hochgradig ionisiert ist und durch Ablenkung in starken Magnetfeldern auf eine versteckte Anode nicht mehr für die Beschichtung zur Verfügung stehen würde.

Bei einer bipolaren Entladung wird die Beschichtung auf der Anode im alternierenden Betrieb als Kathode wieder entfernt. Dieses Prinzip ist auf Bogenentladungen ebenfalls nicht anwendbar. Insbesondere beim gepulsten Kohlenstoff-Hochstrombogen, bei dem die Anode zur sicheren Zündung der Entladung in der Nähe der Kathode angeordnet sein muss, stellen die beschriebenen Aufwachsungen ein großes Problem dar.

Nach dem gegenwärtigen Stand der Technik werden die verwendeten Anoden vornehmlich aus Stahl, Kupfer oder Titan Kernmaterial gefertigt. Die unvermeidlichen Aufwachsungen des graphitischen Kathodenmaterials werden dabei mechanisch, beispielsweise durch abkratzen, abschleifen, abdrehen oder strahlen entfernt. Die durch die mechanische Entfernung des Kathodenmaterials geschädigte Oberfläche wird, im Optimalfall, durch nachfolgende Politur behandelt. In Dokument US 4 478 700 A wird auf eine verschmutzte Anode eine elektrisch leitfähige Schicht aufgebracht und so die durch die Verschmutzung verschlechterten elektrischen Leitfähigkeitseigenschaften wieder in Richtung ursprünglicher elektrischer Leitfähigkeitseigenschaften verschoben werden. In Dokument US 2012/298139 A1 und DE 10 2013 103762 A1 werden metallische Anoden oder Anoden mit metallischen Schichten offenbart.

Die Aufgabe der Erfindung ist es, eine Anode und eine Anodenanordnung in einer Vorrichtung, deren Verwendung sowie die Herstellung einer solchen Anode vorzuschlagen, die die Degradation der positiv geladenen Elektrode, aufgrund von Anlagerungen, stark reduziert oder sogar verhindert.

Die Aufgabe wird gelöst durch die Merkmale der unabhängigen Ansprüche. Bevorzugte Ausgestaltungen sind in den darauf rückbezogenen Unteransprüchen offenbart.

Die erfindungsgemäße Anode weist eine an sich bekannte Form auf. Erfindungsgemäß wird die Degradation durch eine auf der Oberfläche der Anode angeordnete vollständige oder teilweise Bedeckung mit einer haftmindernden Dünnschicht hoher elektrischer Leitfähigkeit (im Folgenden "Dünnschicht") vermieden oder weitgehend reduziert.

Unter Dünnschichten werden flächige Bereiche eines Substrates verstanden, die sich strukturell und/oder stofflich von benachbarten Schichten und dem Substrat, auf dem sie abgeschieden sind, unterscheiden und deren Dicke von wenigen Atomlagen, mindestens aber einer Monolage, bis hin zu 10 µm reicht.

Ein Verfahren zur Oberflächenmodifikation durch Beschichtung bzw. zur Aufbringung einer Dünnschicht auf einem Werkstück ist die physikalische Gasphasenabscheidung bzw. der PVD Prozess ist. Das Werkstück wird im Sinne der vorliegenden Schrift als ein zur Beschichtung vorgesehenes Objekt verstanden und als "Substrat" bezeichnet.

Der im weiteren Verlauf beschriebene Vorgang des Vakuumlichtbogens wird mit den im Sinne dieser Schrift als synonym verwandten Begriffen "Bogenentladung", "Lichtbogen" und "Arc-Entladung" bezeichnet. Diese Phänomene dienen der Erzeugung eines Plasmas. Dies geschieht vornehmlich unter Vakuumbedingungen.

Im Sinne dieser Erfindung ist ein Pumpstand eine Vorrichtung zur Erzeugung und Aufrechterhaltung eines Vakuums innerhalb eines abgeschlossenen Gefäßes.

In dieser Schrift werden Elektroden in den jeweils gegebenen Zusammenhängen als "Anode" und als "Kathode" bezeichnet. Dabei wird unter der Kathode eine Elektrode mit gesamt negativem elektrischem Ladungszustand verstanden. Als Anode wird analog dazu eine Elektrode mit mehrheitlich positivem elektrischem Ladungszustand aufgefasst.

Als eine "heiße Elektrode" wird im Folgenden sowohl eine Anode als auch eine Kathode verstanden, welche vor dem und in ihrem Betriebszustand aktiv bis zum Erreichen einer definierten Temperatur geheizt wird. Die Ausführungsformen der einzelnen Elektroden werden im weiteren Verlauf als "heiße Anode" und "heiße Kathode" bezeichnet.

Die erfindungsgemäße Vorrichtung umfasst ein Gefäß, welches geeignet ist, verschiedene Prozessdrücke, insbesondre im Vakuumbereich, einzuschließen. Im Inneren des Gefäßes sind mindestens zwei von außerhalb des Gefäßes mit einer elektrischen Spannung beaufschlagbare Elektroden angeordnet, wobei mindestens eine der Elektroden als Anode und mindestens eine der Elektroden als Kathode fungiert. Zwischen der Kathode und der Anode wird eine Bogenentladung erzeugt und über einen definierten Zeitraum aufrechterhalten.

Bei diesen Bogenentladungen kommt es zu Materialabtragungen von der Kathode und Ablagerungen auf der Anode. Überraschend hat sich erwiesen, dass durch eine erfindungsgemäß eingesetzte Dünnschicht mit hoher elektrischer Leitfähigkeit die Haftkraft zwischen den Ablagerungen und der Oberfläche der Anode/den Anoden entscheidend reduziert wird. Daher ist erfindungsgemäß mindestens eine der verwendeten Anoden dadurch gekennzeichnet, dass sie eine haftmindernde und elektrisch leitende Dünnschicht aufweist, die die Oberfläche der Anode vollständig oder teilweise bedeckt.

Die auf die Anoden aufgebrachte haftmindernde Dünnschicht mit hoher elektrischer Leitfähigkeit weist dabei bezüglich des Beschichtungsmaterials schlechtere Haftungseigenschaften auf als das unbeschichtete Elektrodenmaterial.

Durch die haftmindernde Dünnschicht mit hoher elektrischer Leitfähigkeit wird das Anhaften der Ablagerungen stark reduziert oder sogar vermieden. Zumindest wird die Beseitigung dieser Ablagerungen deutlich erleichtert. Besonders vorteilhaft ist es, wenn die haftmindernde Dünnschicht in den Bereichen, in denen sie aufgetragen ist, eine geschlossene Oberfläche bildet und nicht mit Poren oder anderen kleinen Durchbrüchen, die eine Anhaftung von Beschichtungsmaterial erleichtern würden, durchsetzt ist.

Vorteilhaft an einer teilweisen Beschichtung der Oberfläche der Elektrode ist der reduzierte Produktionsaufwand. Im Allgemeinen wird dabei während eines Beschichtungsverfahrens das Material der Dünnschicht aufgetragen. Wird nun ein Bereich, des zu beschichtenden Objektes vor der Beschichtung verdeckt, entsteht ein abgeschatteter Bereich, welcher der Beschichtung nicht zur Verfügung steht. Somit können gezielt Flächenbereiche erzeugt werden, die keine Dünnschichtbeschichtung aufweisen. Diese Bereiche können vorteilhaft zur Halterung der Anode genutzt werden.

Die unbeschichteten Bereiche der Anode sind vorteilhaft während des Betriebs in der Lichtbogenanordnung derart angeordnet, dass die unbeschichteten Bereiche verdeckt sind, um ein Anhaften von Kathodenmaterial an ihnen zu vermeiden.

Vorteilhaft an einer vollständigen Beschichtung ist wiederum der vereinfachte Montageaufwand, da insbesondere bei Verwendung von Anoden mit zylindersymmetrischen Querschnitt auf keine spezielle Ausrichtung der Anode innerhalb der Lichtbogenanordnung geachtet werden muss, da die gesamte Oberfläche der Anode eine reduzierte Haftung für Kathodenmaterial bietet.

Die Kathode besteht vorzugsweise vollständig aus einer elektrisch leitfähigen Kohlenstoffmodifikation oder sie weist mindestens an ihrer Oberfläche eine elektrisch leitfähige Kohlenstoffmodifikation auf. Bevorzugt ist die elektrisch leitfähige Kohlenstoffmodifikation ganz oder teilweise aus Graphit gebildet.

Da die Kathode einem ständigen Verschleiß unterliegt und die Anode einer regelmäßigen Reinigung zu unterziehen ist, ist in einer bevorzugten Ausführungsform mindestens eine der Elektroden beweglich und/oder austauschbar angeordnet. Unter "beweglich" werden in diesem Zusammenhang vorzugsweise die Eigenschaften "drehbar", "schwenkbar" und/oder "verfahrbar" verstanden.

Die Dünnschicht ist bevorzugt aus einem Material ausgewählt, welches für hohe Anodentemperaturen geeignet ist, da die Anode bevorzugt als "heiße Anode" ausgeführt ist. Dabei ist es vorteilhaft, wenn die Dünnschicht nur schwer oder bestenfalls keine chemische Verbindung mit dem Beschichtungsmaterial eingeht, also bspw. im Falle von kohlenstoffbasiertem Beschichtungsmaterial, aus einem Material ausgewählt ist, welches nur schwer oder bestenfalls keine chemische Verbindung mit dem Kohlenstoff, z. B. nur schwer oder bestenfalls keine Karbide, bildet. Diese Eigenschaft trägt maßgeblich zur Erzeugung prozessgünstiger Haftungseigenschaften zwischen Beschichtungsmaterial und der Dünnschicht bei.

Die Dünnschicht ist eine Schicht aus Metallnitrid. Dabei ist das Nitrid bildende Metall bevorzugt aus Ti, Zr, Hf, V oder Mischungen dieser Metalle ausgewählt. Nitride mit mehr als einem Metall in der Verbindung zählen zu den bevorzugten Ausführungen, wenn diese einen spezifischen elektrischen Widerstand von mehr als 10 µΩ cm und bis zu 150 µΩ cm aufweisen.

Um einerseits eine geschlossene Oberfläche mit ausreichender Adhäsion zwischen Dünnschicht und dem Kernmaterial der Anode zu erzeugen und andererseits ein Ablösen oder Abreiben der Dünnschicht zu vermieden wird eine Schichtdicke der Dünnschicht von mehr als 0,1 µm und weniger als 3,5 µm, von mehr als 0,5 µm und weniger als 3,2 µm besonders bevorzugt und von 1 µm und weniger als 3 µm insbesondere bevorzugt, gewählt.

Das Vakuumgefäß der Lichtbogenanordnung, in welchem die Beschichtungsprozesse stattfinden, ist bevorzugt mittels einer vakuumtauglichen Verbindung an einen Pumpstand zur Erzeugung und Überwachung eines Vakuums angeschlossen.

In einer weiteren Ausführungsform wird durch die Hülle des Vakuumgefäßes mindestens eine vakuumgeeignete elektrische Durchführung geführt. Diese ist geeignet elektrische Ströme zu führen und mindestens eine der Elektroden elektrisch leitend mit einer außerhalb des Vakuumgefäßes befindliche Spannungsquelle mittels elektrischer Zuleitungen zu verbinden.

In einer weiteren bevorzugten Ausführungsform ist die Vorrichtung zur Lichtbogenanordnung dadurch gekennzeichnet, dass in der Vakuumgefäßwand mindestens eine gasdicht verschließbare Öffnung vorgesehen ist, die das Ein- und Ausschleusen von Gegenständen in das Gefäß ermöglicht. Im Inneren des Gefäßes ist eine Halterung zur Aufnahme mindestens eines Gegenstandes angeordnet, wobei die Halterung leitfähig, jedoch gegen das Gehäuse isoliert ausgeführt ist, und von außerhalb des Gefäßes mit einer elektrischen Spannung beaufschlagt werden kann.

In einer weiteren bevorzugten Ausführungsform ist im Inneren des Gefäßes eine Halterung zur Aufnahme mindestens eines Substrates angeordnet, wobei die Halterung elektrisch isoliert gegen Substrat und Gehäuse ausgeführt ist und nur das Substrat von außerhalb des Gefäßes mit einer elektrischen Spannung beaufschlagt werden kann.

Die Verwendung einer Anode und einer Vorrichtung mit der erfindungsgemäßen Anode nach vorhergehender Beschreibung in einer Beschichtungsanlage zur Beschichtung von Substraten ist bevorzugt, weil dadurch die Betriebsdauer der Vorrichtung bis zum erforderlichen Wechsel der Anode signifikant erhöht wird.

Es hat sich erwiesen, dass die Dünnschicht vorteilhaft eine sehr geringe Rauigkeit aufweist. Dies ist in der verringerten Anhaftungsunterstützung durch eine besonders glatte Oberfläche begründet. Darüber hinaus entstehen auf einer besonders glatten Elektrodenoberfläche weniger Punkte extrem starken Stromflusses, die die Elektrodenoberfläche nachteilig beeinflussen könnten. Um eine sehr geringe Rauigkeit der Dünnschicht zu erzielen, hat es sich als hilfreich erwiesen, die Oberfläche zu polieren.

Besonders bevorzugt werden vor der Aufbringung der Dünnschicht die Elektroden bis zum Erreichen des Spiegelglanzes poliert, da so eine gleichmäßig kontrollierte Aufbringung der Dünnschicht mit hoher elektrischer Leitfähigkeit erreicht werden kann.

Ein Verfahren zur Herstellung einer Anode für die Verwendung in der Beschichtungsanlage, insbesondere zur Durchführung von PVD-Prozessen, ist daher dadurch gekennzeichnet, dass mindestens die als Anode vorgesehene Elektrode die Verfahrensschritte "Polieren" und "Beschichten" durchläuft, wobei vor dem Aufbringen der Dünnschicht das Polieren der Elektrode erfolgt, bis der Wert der Mittenrauheit der polierten Oberfläche bevorzugt einen Wert zwischen 0,1 µm und 0,3 µm, und besonders bevorzugt einen Wert zwischen 0,01 µm und 0,1 µm erreicht, wobei im Anschluss an das Polieren die Aufbringung der Dünnschicht erfolgt und die Dünnschicht nach ihrem Aufbringen ebenfalls poliert wird, bis die Rauheit, der polierten Dünnschichtfläche einen Wert zwischen 0,01 µm und kleiner 0,1 µm erreicht.

Nach Abschluss des Poliervorgangs werden typische Rauheitswerte des Mittenrauwertes der polierten Oberfläche der Dünnschicht von Ra < 0,1 µm oder ein Rautiefe von Rz < 0,7 µm mittels Rauheitsmessgeräte gemessen. Im Falle einer geläppten Oberfläche werden nach Abschluss des Läppvorgangs typische Rauheitswerte des Mittenrauwertes Ra < 0,01 µm oder eine Rautiefe Rz < 0,07 µm mittels taktiler Rauheitsmessgeräte gemessen. Neben den taktilen Rauheitsmessgeräten sind ebenfalls optische Geräte, wie z. B. Lasermikroskope, verwendbar.

Bevorzugt werden die Verfahrensschritte "Polieren" und "Beschichten" mehrfach ausgeführt. Dabei können die Verfahrensschritte "Polieren" und "Beschichten" nach mindestens einmaligem Ausführen entweder gar nicht oder auch in beliebiger Reihenfolge wiederholt.

Die Erfindung wird nachfolgend in mehreren Ausführungsbeispielen beschrieben und in den zugehörigen Figuren dargestellt.

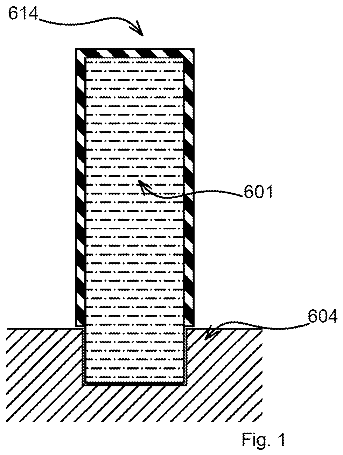

Fig. 1 zeigt schematisch als ein erstes Ausführungsbeispiel den Querschnitt einer mit einer haftmindernden Dünnschicht mit hoher elektrischer Leitfähigkeit beschichteten Anode (614). Die haftmindernde Dünnschicht mit hoher elektrischer Leitfähigkeit ist hier mit einer bevorzugten Schichtdicke von 0,1 µm bis 3,5 µm (624) teilweise auf dem Kernmaterial der Anode (601) aufgebracht. Auf die Beschichtung der Anode wird in diesem Beispiel im Bereich der Einpassung der Anode in eine Elektrodenhalterung mit sacklochförmiger Aussparung (604) verzichtet.

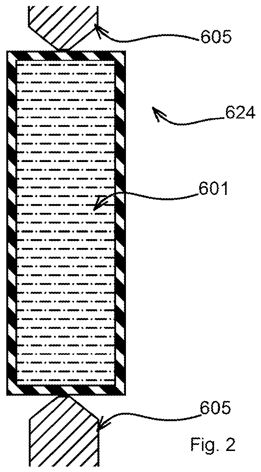

Fig. 2 zeigt schematisch als ein zweites Ausführungsbeispiel den Querschnitt einer vollständig mit einer haftmindernden Dünnschicht mit hoher elektrischer Leitfähigkeit beschichteten Anode (614), welche beispielhaft stirnseitig gehaltert (605) und elektrisch leitend kontaktiert ist.

In einem Ausführungsbeispiel wird in einer mit einer Sensorik zur Überwachung der Prozessbedingungen und einem Pumpstand versehenen Vakuumkammer eine Graphitkathode und eine Anode angeordnet.

Die Vakuumkammer ist zusätzlich mit einer Öffnung versehen, welche gasdicht, insbesondere vakuumdicht, verschließbar ist. Im Inneren der Vakuumkammer ist eine Halterung für die Aufbringung der zur Beschichtung vorgesehenen Substrate vorhanden. Die Halterung selbst ist dabei elektrisch isolierend gegenüber der Prozesskammerwand und elektrisch isolierend gegenüber dem Substrat ausgeführt. Die Substrate werden nach ihrer elektrischen Kontaktierung im Prozess als Hilfsanode geschaltet.

Zuvor wird bei gasdicht verschlossener Öffnung der Vakuumkammerwand, der Prozessdruck in der Vakuumkammer mittels des angeschlossenen Pumpstandes auf ca. 10⁻⁶ hPa eingestellt. Zwischen den Hauptelektroden wird eine elektrische Spannung von ca. 200 V eingestellt.

Durch den Laser der Zündeinrichtung wird auf der Oberfläche der Graphitkathode ein Strahlfleck aus Laserlicht gepulst über einen Zeitraum von ca. 50 ns Länge erzeugt. Dadurch werden Kohlenstoffionen und Elektronen erzeugt und der elektrische Lichtbogen zündet für eine Zeitdauer von ca. 330 µs. Nach Ablauf dieser Zeit wird ein neuer Puls des Strahlflecks aus Laserlicht an einem Ort erzeugt, welcher nicht mit dem vorangegangenen Ort identisch ist. Mit diesem Vorgehen wird die gesamte Kathodenoberfläche abgerastert.

Die verwendete Anode ist dabei mit einer haftmindernden und elektrische leitfähigen Nitridschicht aus TiN beschichtet. Die Schichtdicke der verwendeten Schicht beträgt hierbei ca. 2 µm.

Um die Dünnschicht mit hoher elektrischer Leitfähigkeit auf die Anodenoberfläche auf zu bringen, wurde diese zuvor mechanisch poliert. Die mechanische Politur oder das Läppen der Anodenoberfläche wurde bis zum Erreichen des Spiegelglanzes nach den folgenden Schritten ausgeführt:
1. Vorbereitung der noch unbeschichteten Anode durch Schleifen mit einem Schleifmittel der Korngröße zwischen 80 - 120,
2. Entfernung grober Kratzer durch Schleifen mit Körnung "medium" Korngröße 180- 220,
3. Vorpolieren mit einer Polierscheibe Korngröße 280 - 320 und
4. Polieren mit geeigneter Polierpaste und einer geeigneten Polierscheibe.

Dabei beziehen sich die Korngrößen der genannten Polier- und Schleifmittel auf die Klassifizierung nach dem FEPA-Standard.

### Bezugszeichen

- 601: Anode
- 604: Elektrodenhalterung als sacklochförmige Aussparung
- 605: Elektrodenhalterung als stirnseitige Halterung
- 614: Teilweise beschichtete Anode
- 624: Vollständig beschichtete Anode

## Patentansprüche

1. Anode, geeignet für Prozesse physikalischer Gasphasenabscheidung, wobei die Oberfläche der Anode vollständig oder teilweise mit einer haftmindernden Dünnschicht hoher elektrischer Leitfähigkeit bedeckt ist, wobei die Anode als heiße Anode ausgeführt ist und die Dünnschicht mit hoher elektrischer Leitfähigkeit für hohe Anodentemperaturen geeignet ist, **dadurch gekennzeichnet, dass** die haftmindernde Dünnschicht eine Dicke zwischen 0,1 µm und 3,5 µm aufweist, wobei die haftmindernde Dünnschicht eine keramische Nitridschicht ist.

2. Vorrichtung, für Prozesse physikalischer Gasphasenabscheidung mit einer Anodenanordnung, umfassend ein Gefäß, welches geeignet ist, verschiedene Prozessdrücke einzuschließen, in dessen Innerem mindestens zwei von außerhalb des Gefäßes mit einer elektrischen Spannung beaufschlagbaren Elektroden angeordnet sind, wobei mindestens eine der Elektroden als Anode und mindestens eine der Elektroden als Kathode fungiert, und zwischen Kathode und Anode eine Bogenentladung erzeugt und über einen definierten Zeitraum aufrechterhalten werden kann, wobei mindestens eine der Anoden eine Anode gemäß Anspruch 1 ist.

3. Anode nach Anspruch 1 oder Vorrichtung nach Anspruch 2, wobei das Material der keramischen Nitridschicht ein Metallnitrid aus den Metallen Ti, Zr, Hf und V oder einer Mischung dieser ausgewählt ist.

4. Vorrichtung oder Anode nach Anspruch 3, wobei das ausgewählte Metallnitrid einen spezifischen elektrischen Widerstand zwischen 10 µΩ cm und 150 µΩ cm aufweist.

5. Vorrichtung nach Anspruch 4, wobei die Kathode vollständig aus einer elektrisch leitfähigen Kohlenstoffmodifikation besteht oder dass sie mindestens teilweise an ihrer Oberfläche eine elektrisch leitfähige Kohlenstoffmodifikation aufweist.

6. Vorrichtung nach Anspruch 5, wobei die elektrisch leitfähige Kohlenstoffmodifikation Graphit ist.

7. Vorrichtung nach Anspruch 2, wobei der Abstand zwischen den Elektroden einstellbar ist, wobei mindestens eine der Elektroden beweglich ausgeführt ist.

8. Vorrichtung nach einem der Ansprüche 2 bis 7, wobei mindestens eine der Elektroden austauschbar ausgeführt ist.

9. Verwendung einer Vorrichtung nach einem der Ansprüche 2 bis 8 als Beschichtungsanlage zur Beschichtung von auf einer Halterung aufgebrachten Substraten.

10. Verfahren zur Herstellung einer Anode nach Anspruch 1 für die Verwendung in einer Vorrichtung nach einem der Ansprüche 2 bis 8, wobei die als Anode vorgesehene Elektrode die Verfahrensschritte Polieren und Beschichten durchläuft, wobei vor dem Aufbringen der Dünnschicht das Polieren der Elektrode erfolgt, bis der Wert der Mittenrauheit der polierten Oberfläche zwischen 0,01 µm und 0,3 µm erreicht, wobei im Anschluss daran die Aufbringung der Dünnschicht erfolgt und die Dünnschicht nach ihrer Aufbringung so belassen oder poliert wird, bis der Wert der Mittenrauheit der polierten Dünnschichtfläche einen Wert von größer 0,01 µm und kleiner 0,1 µm erreicht.

11. Verfahren nach Anspruch 10, wobei die Verfahrensschritte "Polieren" und "Beschichten" mehrfach ausgeführt werden.

12. Verfahren nach Anspruch 11, wobei die Verfahrensschritte "Polieren" und "Beschichten" nach einmaligem Ausführen in beliebiger Reihenfolge wiederholt werden.

## Claims

1. Anode suitable for physical vapor deposition processes, the surface of the anode being completely or partially covered with an adhesion-reducing thin film of high electrical conductivity, the anode being designed as a hot
anode and the thin film with high electrical conductivity being suitable for high anode temperatures, **characterized in that** the adhesion-reducing thin film has a thickness between 0.1 µm and 3.5 µm, the adhesion-reducing thin film being a ceramic nitride layer.

2. Device for physical vapor deposition processes with an anode arrangement, comprising a vessel which is suitable for enclosing various process pressures, in the interior of which at least two electrodes are arranged which can be subjected to an electrical voltage from outside the vessel, wherein at least one of the electrodes functions as an anode and at least one of the electrodes functions as a cathode, and an arc discharge is generated between the cathode and the anode and can be maintained over a defined period of time, wherein at least one of the anodes is an anode according to claim 1.

3. Anode according to claim 1 or device according to claim 2, wherein the material of the ceramic nitride layer is a metal nitride selected from the metals Ti, Zr, Hf and V or a mixture thereof.

4. Device or anode according to claim 3, wherein the selected metal nitride has an electrical resistance between 10 µΩ cm and 150 µΩ cm.

5. Device according to claim 4, wherein the cathode consists entirely of an electrically conductive carbon modification or that it has an electrically conductive carbon modification at least partially on its surface.

6. Device according to claim 5, wherein the electrically conductive carbon modification is graphite.

7. Device according to claim 2, wherein the distance between the electrodes is adjustable, wherein at least one of the electrodes is designed to be movable.

8. Device according to any of claims 2 to 7, wherein at least one of the electrodes is designed to be replaceable.

9. Use of a device according to any of claims 2 to 8 as a coating system for coating substrates applied to a holder.

10. Method for producing an anode according to claim 1 for use in a device according to any of claims 2 to 8, wherein the electrode provided as an anode undergoes the method steps of polishing and coating, wherein, before the application of the thin film, the electrode is polished until the value of the mean roughness of the polished surface reaches between 0.01 µm and 0.3 µm, wherein the thin film is subsequently applied and, after application, the thin film is left as it is or is polished until the value of the mean roughness of the polished thin film surface reaches a value of greater than 0.01 µm and less than 0.1 µm.

11. Method according to claim 10, wherein the method steps of "polishing" and "coating" are carried out multiple times.

12. Method according to claim 11, wherein the method steps of "polishing" and "coating" are repeated in any order after being carried out once.

## Revendications

1. Anode, adaptée à des processus de dépôt physique en phase vapeur, dans laquelle la surface de l'anode est entièrement ou partiellement recouverte d'une couche mince antiadhérente à conductivité électrique élevée, dans laquelle l'anode est réalisée
en tant qu'anode chaude et la couche mince à conductivité électrique élevée est adaptée à des températures d'anode élevées, **caractérisée en ce que** la couche mince antiadhérente présente une épaisseur comprise entre 0,1 µm et 3,5 µm, dans laquelle la couche mince antiadhérente est une couche de nitrure céramique.

2. Dispositif pour des processus de dépôt physique en phase vapeur avec un agencement d'anodes, comprenant un récipient qui est adapté à l'enfermement de différentes pressions de processus, à l'intérieur duquel sont disposées au moins deux électrodes pouvant être alimentées en tension électrique depuis l'extérieur du récipient, dans lequel au moins l'une des électrodes sert d'anode et au moins l'une des électrodes sert de cathode, et une décharge en arc peut être générée entre la cathode et l'anode et maintenue pendant une période définie, dans lequel au moins l'une des anodes est une anode selon la revendication 1.

3. Anode selon la revendication 1 ou dispositif selon la revendication 2, dans lequel le matériau de la couche de nitrure céramique est un nitrure métallique choisi parmi les métaux Ti, Zr, Hf et V ou un mélange de ceux-ci.

4. Dispositif ou anode selon la revendication 3, dans lequel le nitrure métallique choisi présente une résistivité électrique spécifique comprise entre 10 µΩ cm et 150 µΩ cm.

5. Dispositif selon la revendication 4, dans lequel la cathode est entièrement constituée d'une forme de carbone électriquement conductrice ou en ce qu'elle présente au moins partiellement à sa surface une forme de carbone électriquement conductrice.

6. Dispositif selon la revendication 5, dans lequel la forme de carbone électriquement conductrice est du graphite.

7. Dispositif selon la revendication 2, dans lequel la distance entre les électrodes est réglable, dans lequel au moins l'une des électrodes est réalisée de manière à être mobile.

8. Dispositif selon l'une des revendications 2 à 7, dans lequel au moins l'une des électrodes est réalisée de manière à être interchangeable.

9. Utilisation d'un dispositif selon l'une des revendications 2 à 8 en tant qu'installation de revêtement pour le revêtement de substrats appliqués sur un support.

10. Procédé pour la fabrication d'une anode selon la revendication 1 pour l'utilisation dans un dispositif selon l'une des revendications 2 à 8, dans lequel l'électrode prévue en tant qu'anode passe par les étapes de procédé de polissage et de revêtement, dans lequel le polissage de l'électrode est effectué avant l'application de la couche mince, jusqu'à ce que la valeur de la rugosité centrale de la surface polie atteigne entre 0,01 µm et 0,3 µm, dans lequel l'application de la couche mince est ensuite effectuée et la couche mince est laissée en place ou polie après son application jusqu'à ce que la valeur de la rugosité centrale de la surface polie de la couche mince atteigne une valeur supérieure à 0,01 µm et inférieure à 0,1 µm.

11. Procédé selon la revendication 10, dans lequel les étapes de procédé « polissage » et « revêtement » sont exécutées plusieurs fois.

12. Procédé selon la revendication 11, dans lequel les étapes de procédé « polissage » et « revêtement » sont répétées dans n'importe quel ordre après avoir été exécutées une fois.
